# EUROPEAN PATENT APPLICATION

(11) **EP 2 385 552 A2**
(43) Date of publication of application: **09.11.2011**
(21) Application number: 11164288.0
(22) Date of filing: 29.04.2011
(51) Int. Cl.: H01L 27/142, H01L 31/18

(54) **See-through solar battery module and manufacturing method thereof**

(30) Priority: 03.05.2010 TW 099114072
(71) Applicant: Axuntek Solar Energy, Pingtung County 900 (TW)
(72) Inventor: Lee, Shih-Wei, 843, Kaohsiung City (TW); Lin, Ching-Ju, Fengshan Dist. Kaohsiung City 830 (TW); Huang, Wei-Min, 116, Taipei City (TW); Hou, Chi-Hung, 100, Taipei City (TW); Chen, Yen-Chun, 330, Taoyuan County (TW)
(74) Representative: Becker Kurig Straus

(57) **Abstract**

A see-through solar battery module (20, 42) includes a transparent substrate (22), a plurality of block metal electrodes (24) formed on the transparent substrate (22), and a plurality of block photoelectric transducing layers (26). Each block photoelectric transducing layer (26) is formed on the corresponding block metal electrode (24) and the transparent substrate (22) along a first direction and formed on the corresponding block metal electrode (24) and the transparent substrate (22) along a second direction. The see-through solar battery module (20, 42) further includes a plurality of striped transparent electrodes (28). Each striped transparent electrode (28) is formed on the corresponding block photoelectric transducing layer (26) and the transparent substrate (22) along the first direction and formed on the corresponding block photoelectric transducing layer (26) and the block metal electrode (24) along the second direction. Each block metal electrode (24) and block photoelectric transducing layer (26) do not contact the adjacent block metal electrode (24) and block photoelectric transducing layer (26) along the first direction.

## Description

### Field of the Invention

The present invention relates to a see-through solar battery module and a related manufacturing method according to the pre-characterizing clause of claims 1 and 8.

### Background of the Invention

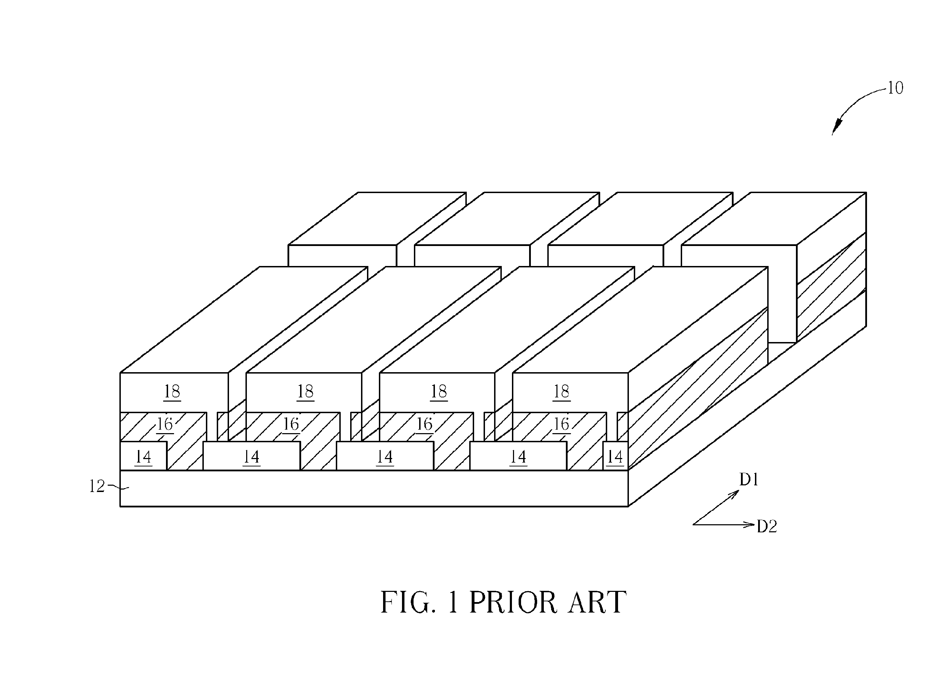

Generally, the conventional solar batteries are classfied as the see-through solar battery and the non see-through solar battery. The non see-through solar battery is widely applied on building material, such as on a tile structure, a hanging, and so on. On the other hand, the see-through solar battery is necessary to be applied on the specific ways, such as on a transparent wall, on a transparent roof, and so on, for preferable aesthetic appearance. Please refer to FIG.1. FIG.1 is a conventional see-through solar battery module 10 in the prior art. The see-through solar battery module 10 includes a transparent substrate 12, a transparent conductive layer 14, a photoelectric transducing layer 16, and an opaque electrode 18. The method of manufacturing the see-through solar battery module 10 is by directly removing parts of the opaque electrode 18 and parts of the photoelectric transducing layer 16 by laser to expose parts of the transparent substrate 12 and parts of the transparent conductive layer 14 for transmitting beams to pass through the see-through solar battery module 10. Due to the high working temperature of the laser, crystals are formed on the transparent conductive layer 14 and the opaque electrode 18 easily, which results in the leaking of current of the see-through solar battery module 10, or further results the short circuit between the transparent conductive layer 14 and the opaque electrode 18. Thus, design of a see-through battery module having preferable photoelectric transducing efficiency and high safety is an important issue of the solar industry.

### Summary of the Invention

This in mind, the present invention aims at providing a see-through solar battery module and a related manufacturing method capable of increasing high production yield and decreasing manufacturing cost thereof.

This is achieved by a see-through solar battery module and a related manufacturing method according to claims 1 and 8. The dependent claims pertain to corresponding further developments and improvements.

As will be seen more clearly from the detailed description following below, the claimed see-through solar battery module includes a transparent substrate, a plurality of block metal electrodes, a plurality of block photoelectric transducing layers and a plurality of striped transparent electrodes.

According to an embodiment, a see-through solar battery module includes a transparent substrate, and a plurality of block metal electrodes formed on the transparent substrate as an array. Each block metal electrode does not contact the adjacent block metal electrode along a first direction. The see-through solar battery module further includes a plurality of block photoelectric transducing layers. Each block photoelectric transducing layer is formed on the corresponding block metal electrode and the transparent substrate along the first direction and formed on the corresponding block metal electrode and the transparent substrate along a second direction different from the first direction as an array, and each block photoelectric transducing layer does not contact the adjacent block photoelectric transducing layer along the first direction. The see-through solar battery module further includes a plurality of striped transparent electrodes. Each striped transparent electrode is formed on the corresponding block photoelectric transducing layer and the transparent substrate along the first direction and formed on the corresponding block photoelectric transducing layer and the corresponding block metal electrode along the second direction, so that the plurality of block metal electrodes and the plurality of striped transparent electrodes are in series connection along the second direction.

According to another embodiment, each striped transparent electrode is formed on the corresponding block photoelectric transducing layer, the corresponding block metal electrode, and the transparent substrate along the second direction.

According to another embodiment, a buffer could be formed between the block photoelectric transducing layer and the striped transparent electrode, the buffer being made of zinc sulphide (ZnS) material and intrinsic zinc oxide (ZnO) material.

According to another embodiment, the block metal electrode is made of molybdenum (Mo) material.

According to another embodiment, the block photoelectric transducing layer is made of copper undium gallium selenide (CIGS) material.

According to another embodiment, the striped transparent electrode is a transparent conductive layer made of aluminum zinc oxide (AZO) material or tin-doped indium oxide (ITO) material.

According to an embodiment, a method of manufacturing a see-through solar battery module includes forming a metal electrode on a transparent substrate, removing parts of the metal electrode along a first direction and a second direction different from the first direction to form a plurality of block metal electrodes arranged as an array, forming a photoelectric transducing layer on the plurality of block metal electrodes and the transparent substrate, removing parts of the photoelectric transducing layer along the first direction to expose parts of the plurality of block metal electrode and removing parts of the photoelectric transducing layer along the second direction to expose parts of the transparent substrate so as to form a plurality of block photoelectric transducing layers arranged as an array, forming a transparent electrode on the plurality of block metal electrodes, the plurality of block photoelectric transducing layers, and the transparent substrate, and removing parts of the transparent electrode along the first direction to form a plurality of striped transparent electrodes arranged in parallel, so that the plurality of striped metal electrodes and the plurality of striped transparent electrodes are in series connection along the second direction.

According to another embodiment, removing the parts of the photoelectric transducing layer along the first direction to expose the parts of the plurality of block metal electrode includes removing the parts of the photoelectric transducing layer along the first direction to expose the parts of the plurality of block metal electrode and the parts of the transparent substrate.

According to another embodiment, the method further includes forming a buffer between the photoelectric transducing layer and the transparent electrode.

According to another embodiment, removing the parts of the transparent electrode along the first direction includes removing the parts of the transparent electrode and the parts of the photoelectric transducing layer along the first direction simultaneously.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof
- FIG.1: is the conventional see-through solar battery module in the prior art,
- FIG.2: is a diagram of the see-through solar battery module according to a preferred embodiment of the invention,
- FIG.3: is a flow chart of the method of manufacturing the see-through solar battery module according to the preferred embodiment of the invention,
- FIG.4 to FIG.11: are sectional views of the see-through solar battery module along the second direction in different procedures according to the preferred embodiment of the invention, and
- FIG.12: is a diagram of the projecting device according to an embodiment of the invention.

### Detailed Description

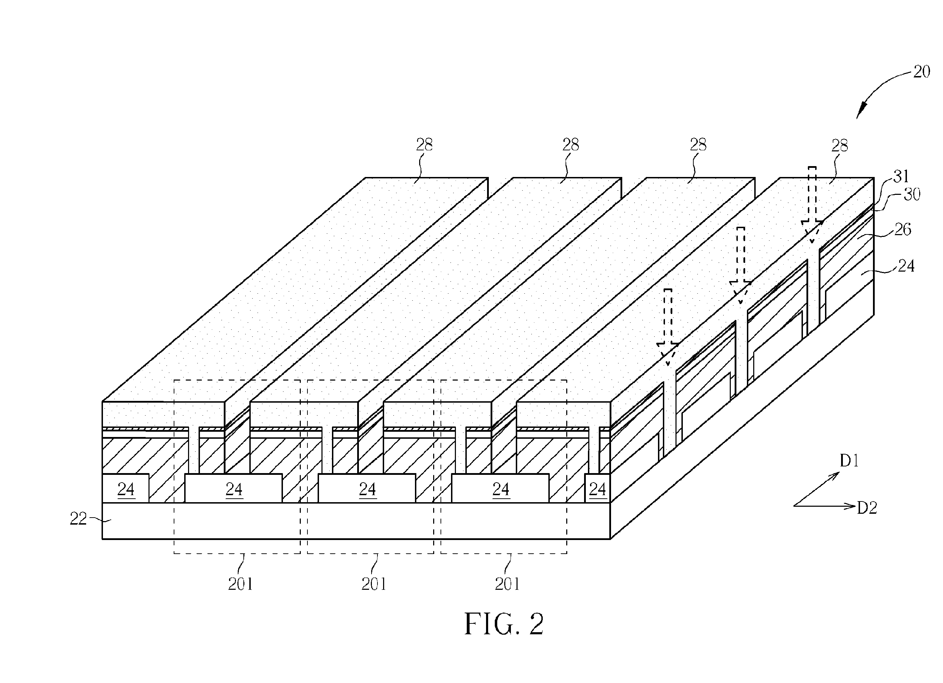

Please refer to FIG.2. FIG.2 is a diagram of a see-through solar battery module 20 according to a preferred embodiment of the invention. The see-through solar battery module 20 includes a transparent substrate 22, and a plurality of block metal electrodes 24 formed on the transparent substrate 22 as an array. Each block metal electrode 24 does not contact the adjacent block metal electrode 24 along a first direction D1. The see-through solar battery module 20 further includes a plurality of block photoelectric transducing layers 26. Each block photoelectric transducing layers 26 is formed on the corresponding block metal electrode 24 and the transparent substrate 22 along the first direction D1, and on the corresponding block metal electrode 24 and the transparent substrate 22 along a second direction D2 different from the first direction D1 as an array, and the block photoelectric transducing layers 26 does not contact the adjacent block photoelectric transducing layer 26 along the first direction D1. The see-through solar battery module 20 further includes a plurality of striped transparent electrodes 28. Each striped transparent electrode 28 is formed on the corresponding block photoelectric transducing layer 26 and the transparent substrate 22 along the first direction D1, and on the corresponding block photoelectric transducing layer 26 and the block metal electrode 24 along the second direction D2. The see-through solar battery module 20 could be consisted of a plurality of solar batteries 201. The block photoelectric transducing layer 26 of the solar battery 201 could transform solar energy into electric power, and the block metal electrode 24 and the striped transparent electrode 28 could respectively be a positive electrode and a negative electrode of the solar battery 201 for outputting the electric power. Therefore, the plurality of block metal electrodes 24 are electrically connected to the plurality of striped transparent electrodes 28 along the second direction D2, which means the plurality of solar batteries 201 are in series connection along the second direction D2, so that a user could adjust an outputting voltage of the see-through solar battery module 20 according to actual demand. In addition, the see-through solar battery module 20 further includes buffers 30, 31 disposed between the block photoelectric transducing layer 26 and the striped transparent electrode 28.

Generally, the transparent substrate 22 could be made of soda-lime glass, the block metal electrode 24 could be made of molybdenum (Mo) material, the block photoelectric transducing layer 26 could be made of copper indium gallium selenide (CIGS) material, the striped transparent electrode 28 could be made of aluminum zinc oxide (AZO) or tin-doped indium oxide (ITO) material, and the buffers 30, 31 could be respectively made of zinc sulphide (ZnS) material and intrinsic zinc oxide (ZnO) material. Material of the transparent substrate 22, the block metal electrode 24, the block photoelectric transducing 26, the striped transparent electrode 28, and the buffers 30, 31 are not limited to the above-mentioned embodiment, and depend on design demand. Due to the transparent property of the soda-lime glass, AZO (or ITO), and the intrinsic ZnO, beams could pass through areas of the see-through solar battery module 20 along the second direction D2 (shown as arrows in FIG.2), and the user could view the scene through the see-through solar battery module 20.

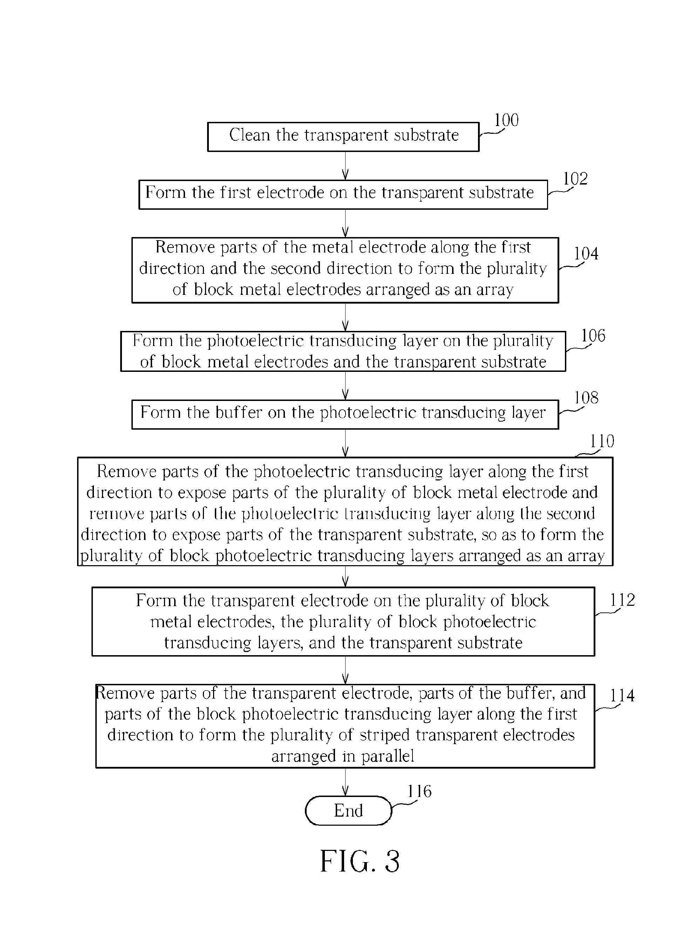

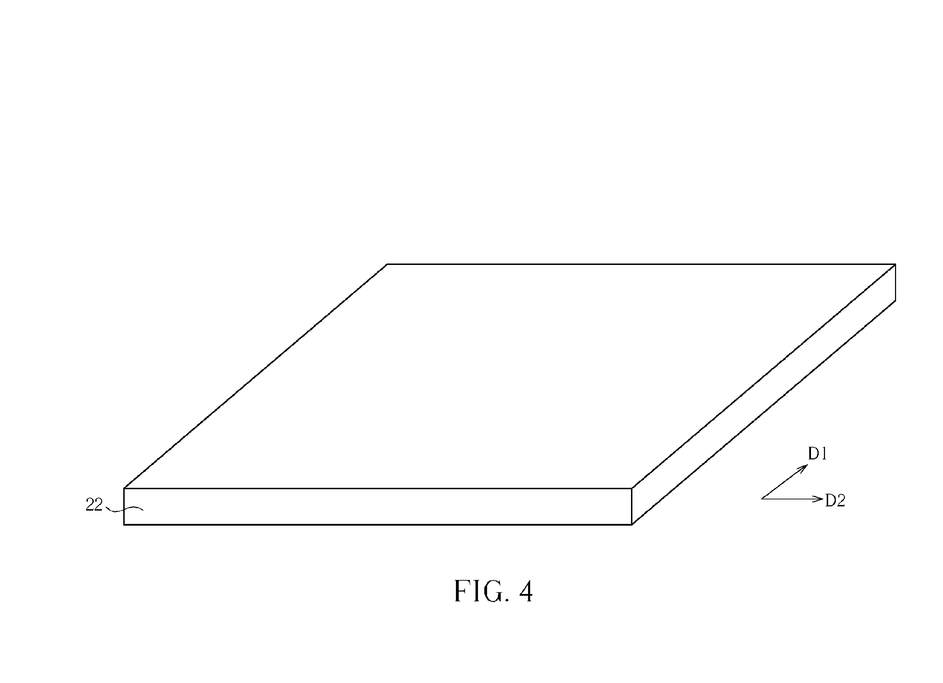

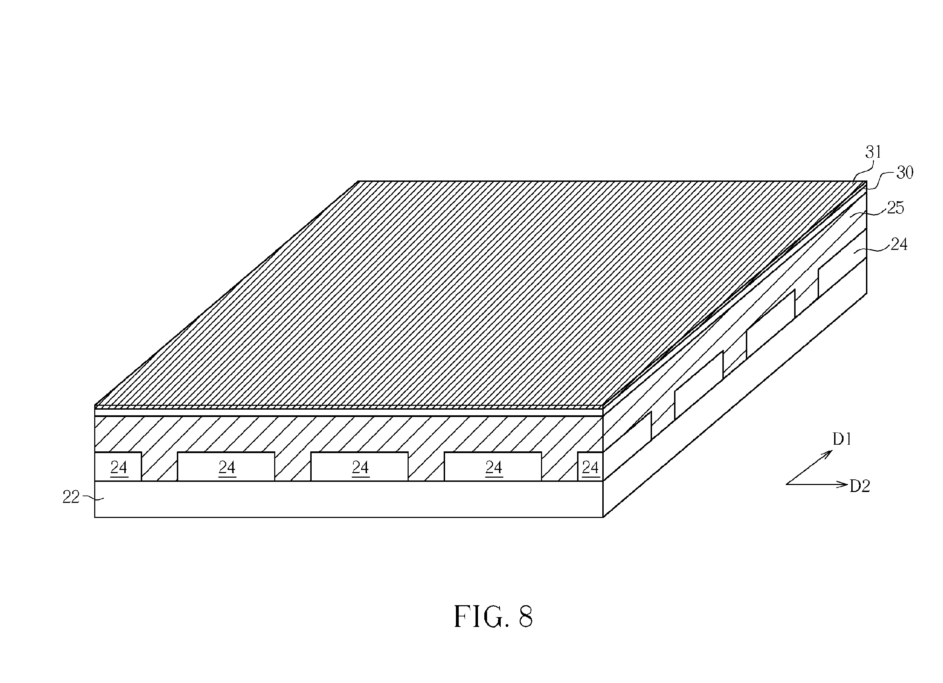

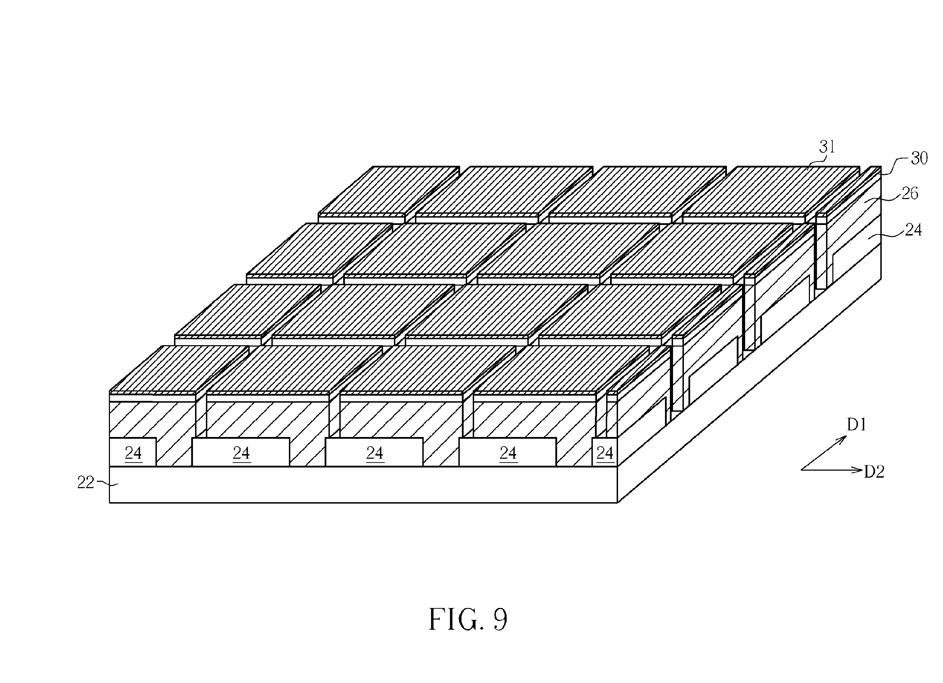

Please refer to FIG.2 and FIG.3 to FIG.11. FIG.3 is a flow chart of the method of manufacturing the see-through solar battery module 20 according to the preferred embodiment of the invention. FIG.4 to FIG.11 are sectional views of the see-through solar battery module 20 along the second direction D2 in different procedures according to the preferred embodiment of the invention. The method includes following steps:
- Step 100:: Clean the transparent substrate 22;
- Step 102:: Form a metal electrode 23 on the transparent substrate 22;
- Step 104:: Remove parts of the metal electrode 23 along the first direction D1 and the second direction D2 to form the plurality of block metal electrodes 24 arranged in parallel and to expose parts of the transparent substrate 22;
- Step 106:: Form a photoelectric transducing layer 25 on the plurality of block metal electrodes 24 and the transparent substrate 22;
- Step 108:: Form the buffer 30 made of the ZnS material and the buffer 31 made of the intrinsic ZnO material on the photoelectric transducing layer 25;
- Step 110:: Remove parts of the photoelectric transducing layer 25 and parts of the buffers 30, 31 along the first direction D1 to expose parts of the plurality of block metal electrodes 24 and remove parts of the photoelectric transducing layer 25 and parts of the buffers 30, 31 along the second direction D2 to expose the parts of the transparent substrate 22, so as to form the plurality of block photoelectric transducing layers 26 arranged as the array;
- Step 112:: Form a transparent electrode 27 on the plurality of block metal electrodes 24, the plurality of block photoelectric transducing layers 26, and the transparent substrate 22;
- Step 114:: Remove parts of the transparent electrode 27, parts of the buffers 30, 31, and the parts of block photoelectric transducing layer 26 along the first direction D1 simultaneously to form the plurality of striped transparent electrodes 28 arranged in parallel, so that the block metal electrode 24 and the striped transparent electrode 28 of the adjacent solar batteries 201 are in series connection along the second direction D2; and
- Step 116:: The end.

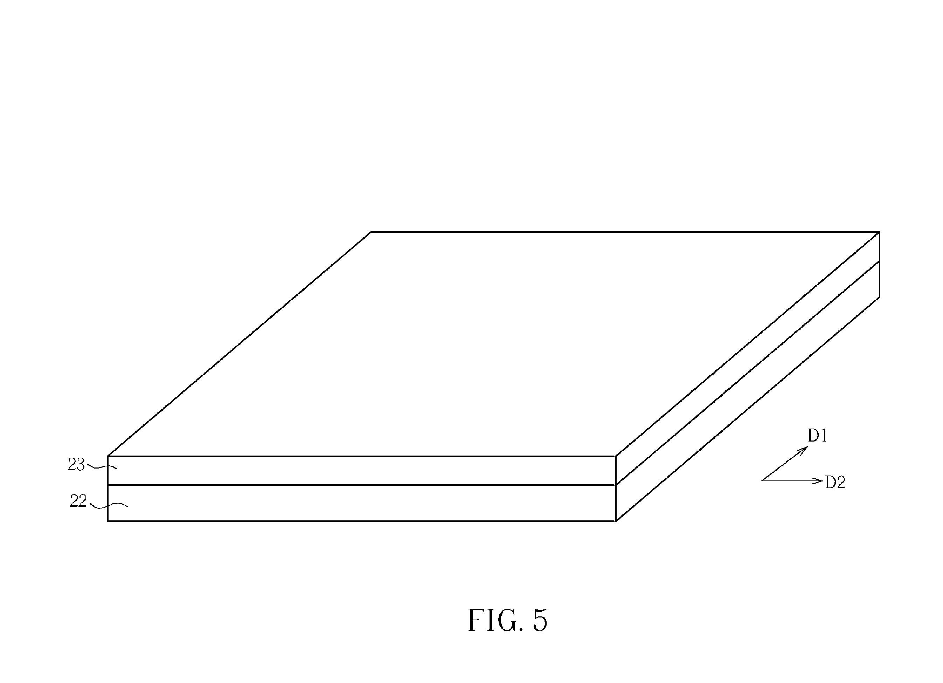

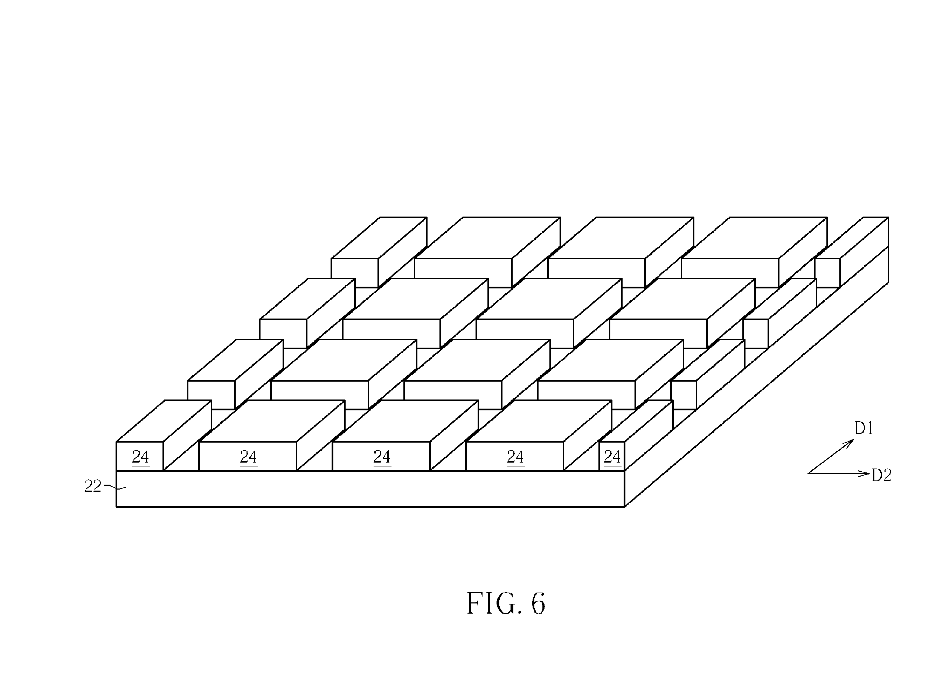

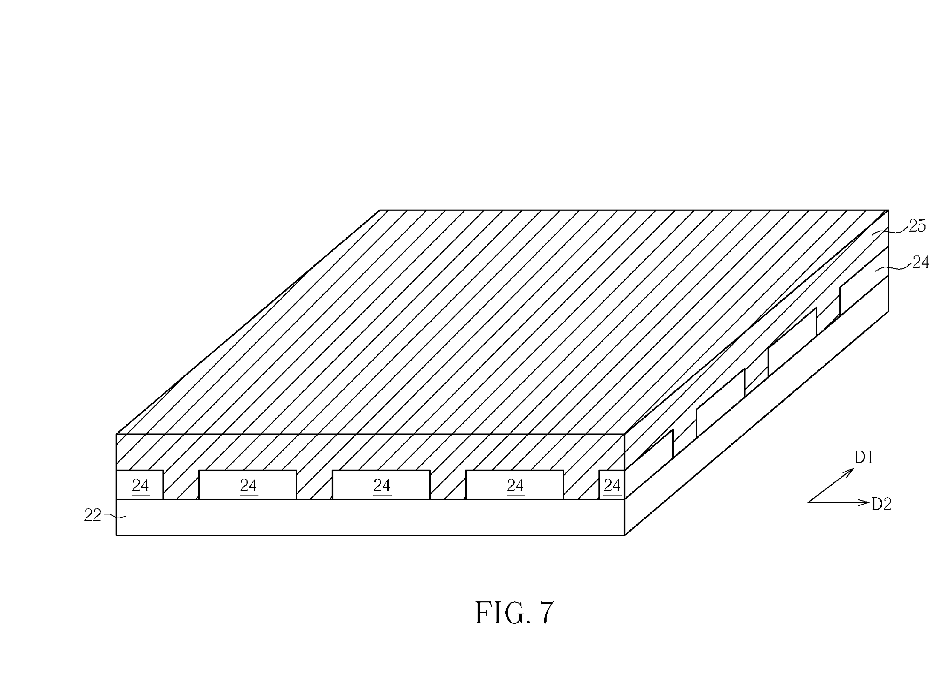

Detailed description of the method is introduced as follows, and step 100 to step 114 corresponds to FIG.4 to FIG.11 respectively. As shown in FIG.4, the transparent substrate 22 is cleaned for preventing dirt from heaping on the transparent substrate 22. At this time, a blocking layer made of Al2O3 or Si02 material could be selectively formed on the transparent substrate 22, for blocking the current from passing. Further, NaF material could be formed on the transparent substrate 22 by evaporation method for crystallizing the CIGS material on the transparent substrate 22. Then, as shown in FIG.5 and FIG.6, the metal electrode 23 made of the Mo material could be formed on the transparent substrate 22 by sputtering or other technology, and the parts of the metal electrode 23 could be removed along the first direction D1 and the second direction D2 by laser technology or other removing technology, so as to expose the parts of the transparent substrate 22 and to form the plurality of block metal electrodes 24 arranged as the array. As shown in FIG.7 to FIG.9, the photoelectric transducing layer 25 could be formed on the plurality of block metal electrodes 24 and the exposed transparent substrate 22 by thin film deposition method or other technology, and the buffer 30 made of the ZnS material and the buffer 31 made of the intrinsic ZnO material could be formed on the photoelectric transducing layer 25. The parts of the photoelectric transducing layer 25 and the parts of the buffers 30, 31 could be removed along the first direction D1 by a scraper method or other removing method to expose the plurality of striped metal electrodes 24, and could further be removed along the second direction D2 to expose the parts of the transparent substrate 22, so that the photoelectric transducing layer 25 is segmented into the plurality of block photoelectric transducing layers 26 arranged as the array. Each block photoelectric transducing layers 26 is formed on the corresponding block metal electrode 24 along the first direction D1 and on the adjacent metal electrodes 24 along the second direction D2. The intrinsic ZnO material could be a transparent film having preferable photoelectric property for increasing the photoelectric transducing efficiency and the electricity generating efficiency of the see-through solar battery module 20. Generally, the thin film deposition could realized by co-evaporation, vacuum sputter, and selenization methods to achieve preferable photoelectric transducing efficiency of the CIGS film.

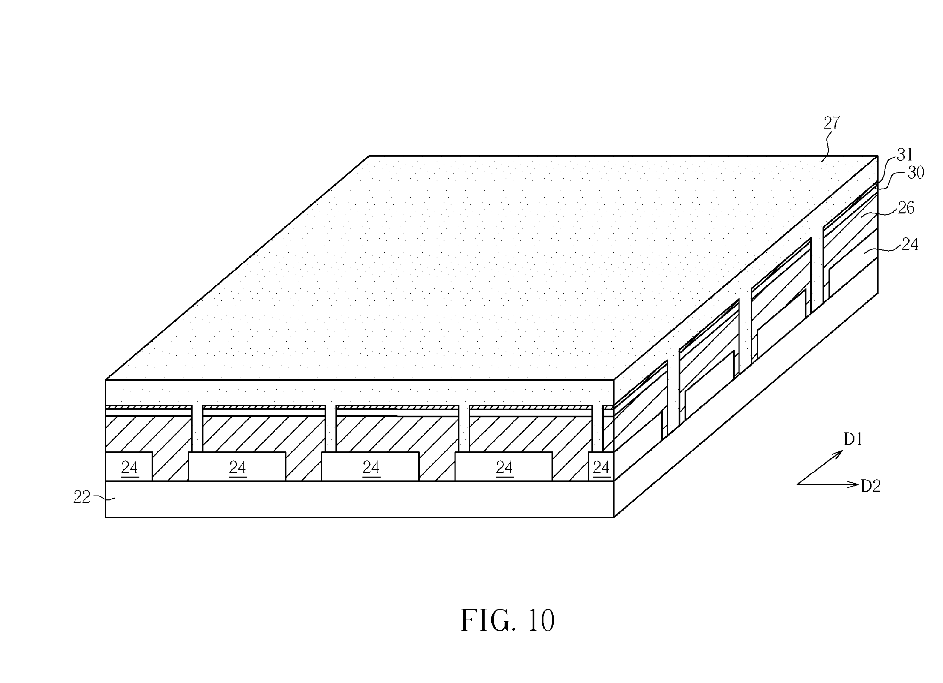

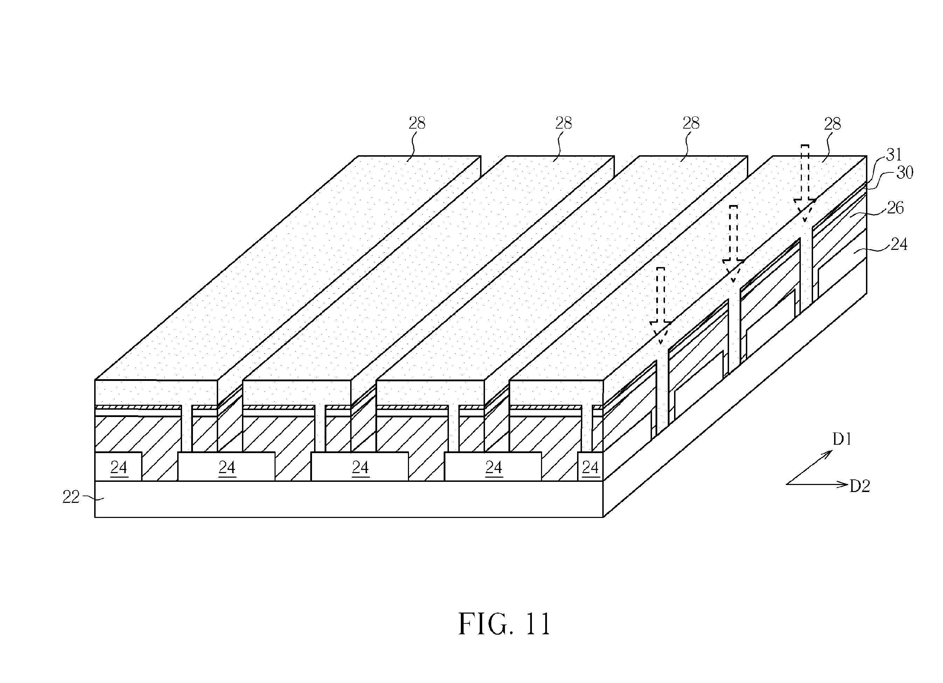

Finally, as shown in FIG.10 and FIG.11, the transparent electrode 27 is formed on the buffer 31, and then parts of the transparent electrode 27 and the parts of the block photoelectric transducing layer 26 are removed along the first direction D1 simultaneously, so as to form the plurality of striped transparent electrodes 28 arranged in parallel. Thus, the see-through solar battery module 20 could include the plurality of solar batteries 201, and the block metal electrode 24 and the striped transparent electrode 28 of the adjacent solar batteries 201 are in series connection along the second direction D2. The transparent areas of the see-through solar battery module 20 are formed by the striped transparent electrode 28 and the transparent substrate 22 for passing the beams (shown as arrows in FIG.11), so that directions of the illumination fringes are different from the disposition of the solar battery 201. Method of the invention could form the transparent substrate 22 and the striped transparent electrode 28 at the predetermined transparent areas, and the striped transparent electrode 28 does not contact the block metal electrode 24 along the first direction D1 by isolation of the block photoelectric transducing layer 26, so that the see-through solar battery module 20 not only has preferable transmittance, but also could prevent two electrodes of the solar battery 201 from short circuit. Material and manufacturing procedures of the buffers 30, 31 are not limited to the above-mentioned embodiment, which is a selectable procedure, and it depends on design demand.

The see-through solar battery module 20 of the invention redesigns the conventional procedures for light transmission and safety. On the other words, the invention could form the transparent substrate 22 and the striped transparent electrode 28 at the predetermined transparent areas, and forms the block photoelectric transducing layer 26 between the striped transparent electrode 28 and the block metal electrode 24 along the first direction D1, so as to prevent the two electrodes of the adjacent solar batteries 201 from short circuit. In addition, the illumination fringes of the see-through solar battery module 20 could not be parallel to the disposition of the solar battery 201, so that the illumination fringes of the see-through solar battery module 20 is not limited to the direction of the solar battery 201, for example, the illumination fringes could be formed as dotted patterns. Further, the dotted patterns could be arranged to form a symbol or a character for increasing practicability of the invention.

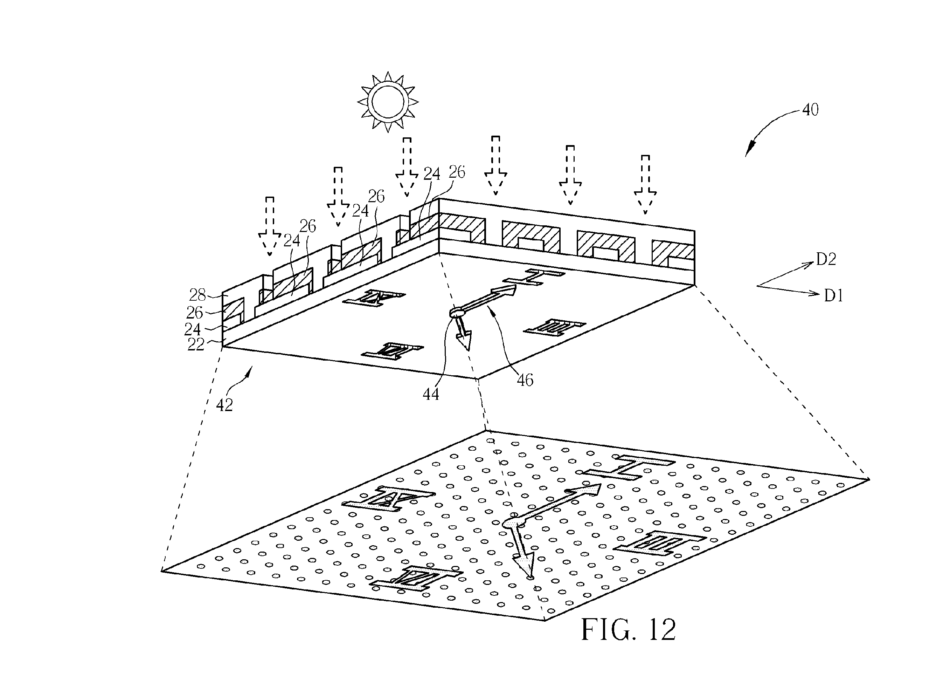

Please refer to FIG.12. FIG.12 is a diagram of a projecting device 40 according to an embodiment of the invention. The projecting device 40 includes a see-through solar battery module 42, a motor 44 disposed on a bottom of the see-through solar battery module 42, and a pointer 46 disposed on the motor 44. Functions and disposal of components of the see-through solar battery module 42 are the same as ones of the see-through solar battery module 20, and the detailed description is omitted herein for simplicity. Comparing to the see-through solar battery module 20, difference of the manufacturing method in the see-through solar battery module 42 is that the parts of the transparent substrate 22 and the parts of the block metal electrode 24 is exposed after removing the parts of the photoelectric transducing layer 25 and the parts of the buffer 30 along the first direction D1 to form the plurality of block photoelectric transducing layer 26 arranged as the array (Step 110), the buffer 31 is formed on the plurality of block photoelectric transducing layer 26, the plurality of block metal electrodes 24, and the parts of the transparent substrate 22 (Step 112), and the transparent electrode 27 is formed on the transparent substrate 22, the plurality of block metal electrodes 24, and the plurality of block photoelectric transducing layer 26 (Step 114). After step 118, each striped transparent electrode 28 of the see-through solar battery module 42 could be formed on the corresponding block photoelectric transducing layer 26, the corresponding block metal electrode 24, and the transparent substrate 22 along the second direction D2. Thus, the transparent areas with the dotted patterns could be formed by the striped transparent electrode 28 and the transparent substrate 22 according to the above-mentioned method, as the arrows shown in FIG.12, so that the beams could pass through the see-through solar battery module 42 along the arrow at the first direction D1 and the second direction D2.

In addition, the dotted patterns could be utilized to form different symbols, such as a numeral. When the projecting device 40 projects the image of the numeral on a projecting curtain, and the pointer 46 is rotated regularly for moving its shadow to point the projecting images of different numerals, the projecting device 40 could be a dynamic projecting pointer, such as a clock. Furthermore, the see-through solar battery module 42 could supply power to the motor 44 for driving the pointer 46, so that the projecting device 40 could be a solar clock. Besides, the pointer 46 could be set on the projecting curtain, and the protecting device 40 could project the images of different numerals on the projecting curtain, so as to form a clock-typed symbol. In conclusion, the invention of the see-through solar battery module could project the images with different patterns, such as the symbol or the character, so that the invention has preferable photoelectric transducing efficiency and wonderful aesthetic appearance.

Comparing to the prior art, the invention redesigns the conventional procedures for preventing short circuit at the transparent areas, so that the method of the invention could increase high production yield and decrease manufacturing cost of the see-through solar battery module. In addition, the invention could project the projecting image with varies patterns, such as the symbol or the character, for increasing the practicability of the see-through solar battery module.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A see-through solar battery module (20, 42) comprising:
a transparent substrate (22);
**characterized by**:
a plurality of block metal electrodes (24) formed on the transparent substrate (22) as an array, and each block metal electrode (24) not contacting the adjacent block metal electrode (24) along a first direction;
a plurality of block photoelectric transducing layers (26), each block photoelectric transducing layer (26) being formed on the corresponding block metal electrode (24) and the transparent substrate (22) along the first direction and formed on the corresponding block metal electrode (24) and the transparent substrate (22) along a second direction different from the first direction as an array, and each block photoelectric transducing layer (26) not contacting the adjacent block photoelectric transducing layer (26) along the first direction; and
a plurality of striped transparent electrodes (28), each striped transparent electrode (28) being formed on the corresponding block photoelectric transducing layer (26) and the transparent substrate (22) along the first direction and formed on the corresponding block photoelectric transducing layer (26) and the corresponding block metal electrode (24) along the second direction so that the plurality of block metal electrodes (24) and the plurality of striped transparent electrodes (28) are in series connection along the second direction.

2. The see-through solar battery module (20, 42) of claim 1, further **characterized in that** each striped transparent electrode (28) is formed on the corresponding block photoelectric transducing layer (26), the corresponding block metal electrode (24), and the transparent substrate (22) along the second direction.

3. The see-through solar battery module (20, 42) of claim 1, further **characterized by**:
a buffer (30, 31) formed between the block photoelectric transducing layer (26) and the striped transparent electrode (28), the buffer (30, 31) being made of zinc sulphide material and intrinsic zinc oxide material.

4. The see-through solar battery module (20, 42) of claim 1, further **characterized in that** the transparent substrate (22) is made of soda-lime glass.

5. The see-through solar battery module (20, 42) of claim 1, further **characterized in that** the block metal electrode (24) is made of molybdenum material.

6. The see-through solar battery module (20, 42) of claim 1, further **characterized in that** the block photoelectric transducing layer (26) is made of copper undium gallium selenide material.

7. The see-through solar battery module (20, 42) of claim 1, further **characterized in that** the striped transparent electrode (28) is a transparent conductive layer made of aluminum zinc oxide material or tin-doped indium oxidematerial.

8. A method of manufacturing a see-through solar battery module (20, 42) **characterized by**:
forming a metal electrode (23) on a transparent substrate (22);
removing parts of the metal electrode (23) along a first direction and a second direction different from the first direction to form a plurality of block metal electrodes (24) arranged as an array;
forming a photoelectric transducing layer (25) on the plurality of block metal electrodes (24) and the transparent substrate (22);
removing parts of the photoelectric transducing layer (25) along the first direction to expose parts of the plurality of block metal electrode (24) and removing parts of the photoelectric transducing layer (25) along the second direction to expose parts of the transparent substrate (22), so as to form a plurality of block photoelectric transducing layers (26) arranged as an array;
forming a transparent electrode (27) on the plurality of block metal electrodes (24), the plurality of block photoelectric transducing layers (26), and the transparent substrate (22); and
removing parts of the transparent electrode (27) along the first direction to form a plurality of striped transparent electrodes (28) arranged in parallel, so that the plurality of striped metal electrodes (24) and the plurality of striped transparent electrodes (27) are in series connection along the second direction.

9. The method of claim 8, further **characterized in that** removing the parts of the photoelectric transducing layer (25) along the first direction to expose the parts of the plurality of block metal electrode (24) comprises removing the parts of the photoelectric transducing layer (25) along the first direction to expose the parts of the plurality of block metal electrode (24) and the parts of the transparent substrate (22).

10. The method of claim 8, further **characterized by**:
cleaning the transparent substrate (22) before forming the metal electrode (23) on the transparent substrate (22).

11. The method of claim 8, further **characterized by**:
forming a buffer (30, 31) between the photoelectric transducing layer (25) and the transparent electrode (27).

12. The method of claim 8, further **characterized in that** removing the parts of the metal electrode (23) along the first direction and the second direction comprises utilizing a laser to segment the metal electrode (23) along the first direction and the second direction.

13. The method of claim 8, further **characterized in that** removing the parts of the photoelectric transducing layer (25) along the first direction and the second direction comprises utilizing a scraper to remove the parts of the photoelectric transducing layer (25) along the first direction and the second direction.

14. The method of claim 8, further **characterized in that** removing the parts of the transparent electrode (27) along the first direction comprises utilizing a scraper to remove the parts of the transparent electrode (27) along the first direction.

15. The method of claim 7, further **characterized in that** removing the parts of the transparent electrode (27) along the first direction comprises removing the parts of the transparent electrode (27) and the parts of the photoelectric transducing layer (25) along the first direction simultaneously.
